(19)

Europäisches
Patentamt
European
Patent Office
Office européen
des brevets

(11)  **EP 3 238 276 B1**

(12) **EUROPEAN PATENT SPECIFICATION**

(45) Date of publication and mention
of the grant of the patent:
**31.07.2019  Bulletin 2019/31**

(51) Int Cl.:
***H01L 31/18*** *(2006.01)*

(21) Application number: **14851441.7**

(22) Date of filing: **22.12.2014**

(86) International application number:
**PCT/IB2014/003118**

(87) International publication number:
**WO 2016/102990 (30.06.2016 Gazette 2016/26)**

(54) **PASSIVATION OF METALLIC IMPURITIES IN A SINGLE CRYSTALLINE REGION BY HYDROGENATION**

PASSIVIERUNG VON METALLISCHEN VERUNREINIGUNGEN IN EINER MONOKRISTALLINEN REGION DURCH HYDRIERUNG

PASSIVATION OF METALLIC IMPURITIES IN A SINGLE CRYSTALLINE REGION BY HYDROGENATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**01.11.2017  Bulletin 2017/44**

(73) Proprietor: **Commissariat à l'Énergie Atomique et aux Énergies Alternatives**
**75015 Paris (FR)**

(72) Inventors:
- **DUBOIS, Sébastien**
  **F-74950 Scionzier (FR)**
- **ENJALBERT, Nicolas**
  **F-81100 Burlats (FR)**
- **GARANDET, Jean-Paul**
  **F-92210 Saint-Cloud (FR)**
- **MARTEL, Benoît**
  **F-73200 Gilly Sur Isere (FR)**
- **TURMAGAMBETOV, Tleuzhan**
  **F-73370 Le Bourget Du Lac (FR)**
- **VEIRMAN, Jordi**
  **F-74330 Poisy (FR)**

(74) Representative: **Nony**
**11 rue Saint-Georges**
**75009 Paris (FR)**

(56) References cited:
- **AZZIZI A ET AL: "HYDROGEN PASSIVATION OF IRON IN CRYSTALLINE SILICON", 19TH EUROPEAN PHOTOVOLTAIC SOLAR ENERGY CONFERENCE,, 7 June 2004 (2004-06-07), pages 1021-1024, XP007923228,**
- **DUBOIS S ET AL: "Effect of intentional bulk contamination with iron on multicrystalline silicon solar cell properties", JOURNAL OF APPLIED PHYSICS, AMERICAN INSTITUTE OF PHYSICS, US, vol. 102, no. 8, 19 October 2007 (2007-10-19), pages 83525-83525, XP012102067, ISSN: 0021-8979, DOI: 10.1063/1.2799057 cited in the application**
- **DUBOIS S ET AL: "Influence of iron contamination on the performances of single-crystalline silicon solar cells: Computed and experimental results", JOURNAL OF APPLIED PHYSICS, AMERICAN INSTITUTE OF PHYSICS, US, vol. 100, no. 2, 26 July 2006 (2006-07-26) , pages 24510-024510, XP012089526, ISSN: 0021-8979, DOI: 10.1063/1.2218593 cited in the application**
- **MARTINUZZI S ET AL: "Hydrogen passivation of defects in multicrystalline silicon solar cells", SOLAR ENERGY MATERIALS AND SOLAR CELLS, ELSEVIER SCIENCE PUBLISHERS, AMSTERDAM, NL, vol. 80, no. 3, 1 November 2003 (2003-11-01), pages 343-353, XP004468024, ISSN: 0927-0248, DOI: 10.1016/J.SOLMAT.2003.08.015 cited in the application**

## Description

The present invention relates to a hydrogenated silicon substrate, to a process for hydrogenating a silicon substrate and to a process for passivizing metallic impurities contained in a silicon substrate.

The conversion rate of a photovoltaic cell comprising a silicon substrate is usually limited by the presence of metallic impurities contained in the silicon substrate, as for example iron (Fe) or aluminum (Al). These metallic impurities enhance the carrier recombination and therefore prevent minority charge carriers to reach the pn junction, thus lowering the electric properties of the silicon substrate and the photovoltaic conversion efficiency of the associated solar cell.

Inside silicon, hydrogen (H) is known to interact with crystallographic flaws, either extended (such as dislocations or twins) or isolated (such as vacancies or impurities). The interaction of hydrogen with crystallographic flaws modifies the charge carrier transport and recombination properties (their mobility and lifetime). Furthermore, hydrogen is also known to interact with metallic impurities in order to promote their electrical passivation, in particular with those which strongly affect the charge carrier lifetime. In other words, it is known that improvement of the electrical properties of a silicon substrate comprising metallic impurities might be obtained by introducing hydrogen therein.

In particular, Dubois *et al.* [1] have shown that during the manufacturing of a photovoltaic solar cell, hydrogen originating from the hydrogenated silicon nitride (SiNx:H) antireflection coating deposited on a face of a multi crystalline silicon substrate, does migrate during a subsequent annealing throughout the whole thickness of the substrate, in particular thanks to the presence of dislocations which core acts as a diffusion canal for hydrogen. However, multi crystalline substrates, in particular when obtained throughout the directional solidification technique, are characterized by the presence of grain boundaries and by a high average dislocation density, typically greater than $10^4$ cm$^{-2}$. Furthermore, in a multi crystalline substrate, the dislocation distribution throughout the bulk of the substrate is not well controlled, and dislocations usually gather in the form of localized clusters, wherein the dislocation density is greater than $10^8$ cm$^{-2}$. These high average dislocation density, high number of clusters and the presence of grain boundaries lower the photovoltaic performances of a cell made from such a multi crystalline substrate.

As in a multi crystalline silicon substrate, when a hydrogenated silicon nitride (SiNx:H) antireflection layer is laid down on a face of a single crystalline silicon substrate, hydrogen originating from said layer diffuses during a subsequent thermal annealing in the bulk of said substrate (see for instance [3]). However, in comparison with a multi crystalline substrate, Dubois *et al.* [2] have shown that hydrogen diffusion would be limited to very few tenths of microns below the single crystalline substrate face (indeed up to 50 $\mu$m at most, which is far lower than the typical 200 $\mu$m thickness of a substrate intended for photovoltaic applications). Nevertheless, diffusion through greater distances in the thickness of a single crystalline substrate might be achieved, thanks to a thermal annealing. However, such a thermal annealing cannot comply with an industrial yield for the production of photovoltaic devices. As a consequence, from a practical point of view, enriching with hydrogen a single crystalline silicon substrate especially intended for a photovoltaic cell still remains difficult to achieve, in particular such that hydrogen is spread throughout the entire bulk of said substrate.

AZZIZI A ET AL: "HYDROGEN PASSIVATION OF IRON IN CRYSTALLINE SILICON", 19TH EUROPEAN PHOTOVOLTAIC SOLAR ENERGY CONFERENCE, 2004, pages 1021-1024, describes results of hydrogen passivation in floatzone silicon wafers. Furthermore, among silicon materials for photovoltaic applications, silicon single crystals are generally preferred for photovoltaic applications, in particular since they are compatible with the standard KOH texturation step, they do not contain any grain boundary and their mean dislocation density is low, typically lower than $10^2$ cm$^{-2}$. Low purity silicon substrates may be produced, either by simplifying the purification process or by lowering the crucible purity used for crystallizing substrates. However, so obtained silicon substrates have a high impurity content. Impurities that diffuse quickly in silicon are usually considered not to be detrimental to the final electric properties (as for example copper which diffusion coefficient is $3 \times 10^{-7}$ cm$^2$.s$^{-1}$ at 850°C, cobalt, nickel or iron), since they might be extracted from the silicon substrate by a well-known "external gettering scheme" during the production of a photovoltaic cell made from said substrate. However, metallic impurities that diffuse slowly are difficult to extract from the substrate (such as aluminum which diffusion coefficient is $2 \times 10^{-15}$ cm$^2$.s$^{-1}$ at 850°C, vanadium or titanium) and lower the electrical properties. For instance, aluminum (at a concentration equal to $2 \times 10^{16}$ cm$^{-3}$) may lower the photovoltaic conversion efficiency by a factor of up to 1.7. For these reasons, high purity single crystalline silicon substrates, which present a low metallic impurity content of less than $10^{13}$ cm$^{-3}$ present good electrical performances and are therefore preferred for photovoltaic applications However, their production method is complex, lengthy and costly.

Therefore, there exists a need for a single crystalline silicon substrate having good electrical properties, while compatible with industrial yield and cost constraints to produce said substrate.

The present invention aims at satisfying at least partially these needs, and succeeds in it by providing a substrate comprising at least a single-crystalline silicon region having a thickness between two opposite faces, characterized in that said region has, in a vertical cross-section plan, a hydrogen rich zone which extends from at least a surface of one of the two opposite faces, in the vertical direction over at least 50% of the thickness of said single crystalline region, and in which the average dislocation density is greater than or equal to $10^3$ cm$^{-2}$ and characterized in that a part of the surface of one of the two opposite faces of the said region facing to the hydrogen rich zone comprises strain high areas separated by a strain low area, the distance between two successive strain high areas being comprised between 5 $\mu$m and 50% of said thickness of said single crystalline silicon region.

Advantageously, the electrical properties of a silicon substrate comprising a hydrogen rich zone according to the invention are improved as compared to a substrate not comprising hydrogen on the one side or comprising hydrogen which has diffused only on few several tenths microns below the substrate surface as in the prior art on the other side.

The invention also relates to a process for hydrogenating a single-crystalline region of a silicon substrate, comprising at least the following steps:

a) providing a substrate comprising a single-crystalline silicon region having a thickness e and at least one external surface;

b) forming crystallographic flaws at predefined areas of said external surface, said areas so called strain high areas being separated by a distance *d*, measured along a direction normal to the vertical direction in a vertical cross-section plan *P,* comprised between 5 $\mu$m and 50% of said thickness,

c) annealing at least said single-crystalline silicon region with conditions suitable for the propagation of dislocations from said crystallographic flaws along the vertical direction trough at least 50% of said thickness *e,*

d) contacting with hydrogen at least one external surface of said region with conditions suitable for the diffusion of hydrogen through or up to the dislocations created at step c).

A process for hydrogenating according to the invention is advantageously suitable for industrial use, since hydrogen diffusion throughout the bulk of the silicon region may be achieved more efficiently and faster than with prior art processes. Furthermore, thanks to the process for hydrogenation according to the invention, the electrical properties of the silicon substrate are not lowered, since the spatial distribution and density of the crystallographic flaws and of the propagated dislocations is controlled and does not result in a detrimental formation of dislocations clusters of high dislocation density.

The invention also relates to a process for the passivation of metallic impurities contained in a single crystalline region by hydrogenation of said single crystalline region via a process according to the invention.

Advantageously, the electrical properties of a silicon substrate comprising metallic impurities, after being processed with the passivation method according to the invention are as good as the electrical properties of a silicon substrate having a higher silicon purity.

Last, the invention relates to a photovoltaic device, in particular a photovoltaic cell comprising a silicon substrate according to the invention or obtained by the process according to the invention.

In the following, and unless otherwise stated, the substrate is observed in a horizontal position, that is a position that is normal to the vertical direction, corresponding to the direction of the gravity.

The "thickness" of the substrate is the dimension that is parallel to the vertical direction. It corresponds to the smallest value measured considering all the possible horizontal positions of the substrate.

A "face" of a substrate is an external surface which is substantially normal to the vertical direction. Two opposite "faces" of the substrate are separated by the thickness of the substrate.

A region which does not comprise any grain boundary is considered to be a "single-crystalline region".

By "substrate" one can equivalently consider a "plate" or a "wafer".

The term "crystallographic flaws" refers to defects classically known in single crystalline material such as dislocations, voids, twins, self-interstitials or vacancies.

A "strain high area" and a "strain low area" are defined by the ratio of their respective strain value corresponding to $\Delta L/L$, L being the initial length of a material and $\Delta L$ being the variation of said length when a deformation (also called a strain) is applied to the material. The strain value can be determined by n-XRD (nano X-ray diffraction). In the case of the present invention, the ratio between the strain value of a strain high area and the strain value of a strain low area is at least greater than 2 and preferably greater than 3.

The term "impurities" is understood to mean the inevitable constituents unintentionally introduced with the raw materials required for producing a substrate, which are different from silicon In particular, metallic elements Fe, Al, Cu, V, Ti, Ni, Co are impurities. The "impurity concentration" is expressed as the number of impurity atoms or molecules per volume. Typically, it is expressed in cm$^{-3}$.

In the context of the present invention, by "passivation" of a metallic impurity, one considers the operation wherein hydrogen associates with an impurity contained in said substrate such as to neutralize the influence of this impurity on electrical properties of the substrate.

A "hydrogen rich zone" is a zone extending from the single crystalline silicon region external surface throughout at least 50% the thickness of said region, and comprising an average hydrogen concentration at least 1.5 times greater, even 2 times greater, even more 5 times greater than the average hydrogen concentration of a neighboring zone.

In the following the expression "comprised between... and..." means that the limits are included, unless otherwise stated.

Unless otherwise stated the expression "comprising a" must be understood as "comprising at least one".

Other features, advantages of a silicon substrate according to the invention and ways of applying a process for hydrogenation according to the invention and for passivation according to the invention will be apparent in the following detailed description, embodiments, example and attached drawing wherein:

- figure 1 illustrates different steps of a process according to the invention, according to a first embodiment,
- figure 2 illustrates different steps of a process according to the invention, according to a second embodiment, as illustrated in the example, and
- figure 3 illustrates in a vertical cross section plan a substrate structure having a single-crystalline region according to the invention.

For clarity reasons, it might be noted that several elements on the figures are represented in free scale, the actual dimensions of the different part not being represented.

## Process for the hydrogenation of a substrate

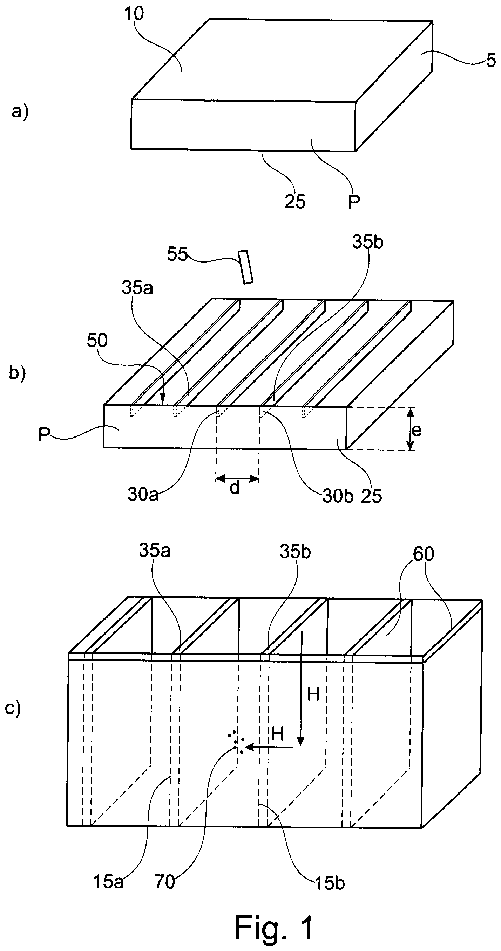

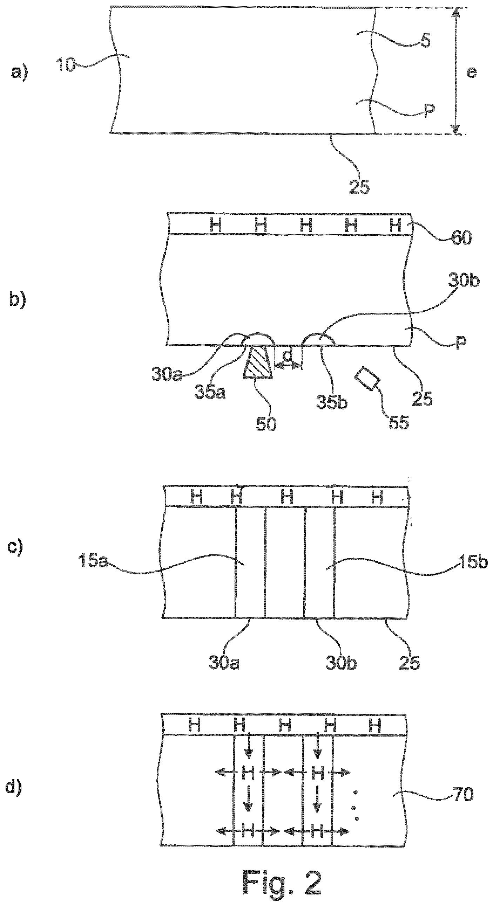

Reference is now made to figures 1 and 2.

### a) Silicon substrate at step a)

At step a), the process of the invention consists in providing a substrate 5, also named starting substrate, comprising a single-crystalline silicon region 10, and having an external surface 25.

The volume of the single crystalline silicon region may represent at least 30%, at least 50%, at least 70%, at least 90%, at least 95%, at least 99%, sensibly 100% of the volume of the substrate. In a preferred embodiment, the substrate is wholly made of a single crystalline silicon region; in other words, the substrate may be a single crystalline silicon substrate.

The substrate may have preferably the form of a block, which length is preferably between 5 to 30 cm, more preferably between 10 to 20 cm and/or which width is between 5 to 30 cm, in particular between 10 to 20 cm.

The length of the substrate may be greater than or equal to its width, in particular comprised between one time and five times its width.

The thickness of the single crystalline silicon region is preferably at least 10 $\mu$m, preferably comprised between 10 $\mu$m to 800 $\mu$m, in particular comprised between 20 $\mu$m to 300 $\mu$m, and more particularly of about 200 $\mu$m.

Preferably, the two opposite faces of the substrate are parallel.

In an embodiment, the single crystalline silicon region opens through the external surface on at least one face and extends in the vertical direction over at least 5%, over at least 10%, at least 50%, at least 99%, substantially over the whole thickness of the substrate, when observed in a vertical cross section plan $P$.

Preferably, the single crystalline silicon region opens on the two opposite faces of the substrate.

Preferably, the single crystalline silicon region has (100) crystallographic plans normal to the vertical direction, (111) plans being known to be preferential propagation plans for dislocation motion in silicon. Preferably, the single-crystalline region has crystallographic plans (100) being normal to the external surface.

In particular, the content of metallic impurities having a diffusion coefficient of less than or equal to $3.10^{-7}$ cm$^2$.s$^{-1}$ at 850°C, may be greater than $10^{10}$ cm$^{-3}$, even more than $10^{12}$ cm$^{-3}$. In particular, the metallic impurities having a diffusion coefficient of less than or equal to $3.10^{-7}$ cm$^2$.s$^{-1}$ at 850°C may be aluminum (Al), vanadium (V) and/or titanium (Ti) and mixtures thereof.

All the features described here above concerning the starting substrate are not substantially modified by the steps b) to e) of the process for hydrogenating described hereafter. Therefore, such features may also characterize a substrate processed with the process for hydrogenating a substrate according to the invention.

The substrate at step a) may be obtained through classical single crystalline growth techniques. A man skilled in the art knows how to obtain such a substrate, for example by cutting a silicon ingot processed via the Czochralski pulling method (Cz), by the fusion zone method (Fz), by the gradient freeze cooling method, by the liquid or gaseous way epitaxy growth method, or even by the seed-assisted directional solidification method

Preferably, the dislocation density of the single crystalline silicon region is less than or equal to $10^3$ cm$^{-2}$, even less than or equal to $10^2$ cm$^{-2}$.

The substrate at step a) may comprise a hydrogen rich zone prior to being hydrogenated with the process according to the invention. However, in a preferred embodiment, at step a), the content of hydrogen in the substrate is less than $10^{13}$ cm$^{-3}$. In particular, the substrate at step a), and more specifically the single crystalline silicon region comprises a content of hydrogen less than $10^{12}$ cm$^{-3}$.

### b) Formation of crystallographic flaws

The process for hydrogenating a substrate according to the invention comprises a step b) of forming superficial crystallographic flaws (30a; 30b) at predefined areas of said external surface (35a; 35b), said areas being separated by a distance $d$, measured along a direction normal to the vertical direction in a vertical cross-section plan P, comprised between 5 $\mu$m and 50% of the thickness.

Preferably, the predefined areas at step b) are spaced from a distance ranging between 5 $\mu$m and 100 $\mu$m, in particular lower than 75 $\mu$m, and more particularly ranging between 10 $\mu$m and 50 $\mu$m.

In particular, the distance $d$ between two predefined areas is less than 0.5 x $e$ (0.5 times $e$), $e$ being the thickness of the single crystalline silicon region. The predefined areas of the external surface preferably form a grid pattern or a pattern of substantially parallel bands, when observed along the vertical direction.

The crystallographic flaws are formed by deforming plastically a part of the single crystalline silicon region located below the predefined areas. Said deformation may be obtained by mechanically loading the predefined areas, for example by applying a force or a displacement on the predefined areas. Said predefined areas are then called "strain high areas".

As illustrated figure 1b), the predefined areas may present several kinds of shape, for example they may present the form of a square, or of a band.

Preferably, the predefined areas have the form of bands or scratches, in particular parallel the one with the others They may extend from one side to the other side of the single crystalline region, along the length or along the width of the substrate. These bands or scratches notably present a width, measured in the vertical cross section plan $P$, which is less than or equal to 10 $\mu$m, in particular of between 0.1 $\mu$m to 10 $\mu$m.

Crystallographic flaws may be formed either on a single face or on the both opposite faces of a single crystalline silicon region, provided the single crystalline region opens on both opposite faces. The step b) of forming crystallographic flaws might be carried out at different temperatures. Preferably, the temperature at which step b) is carried out at a room temperature of 25°C.

In a first embodiment, the crystallographic flaws are formed by scratching the predefined areas of the external surface with a tip (50), in particular with a diamond type or metallic type. Among these materials, a diamond tip is preferred.

In particular, step b) of forming crystallographic flaws might be performed thanks to one or several operations of compression, for example uniaxial compression, and/or to one or more operations of shearing of the predefined areas, for example with the help of one or more tips.

The compression operation consists in compressing the predefined area with said tip(s) in order that the tip modifies locally the relief of the face of the single crystalline silicon region in a non-reversible manner, such as to plastically deform the single crystalline silicon region.

In particular, a deformed predefined area presents, at the end of the compression step, a shape which is sensibly a complement of the tip shape which has been used for applying the compression.

A shear operation consists more specifically in contacting said tip with the predefined area, then in displacing said tip along at least one parallel direction to the face of the substrate, in order to introduce a shear plastic deformation, which results in the formation of crystallographic flaws.

In a preferred embodiment, step b) is performed with the help of a comb, made of several rigid tips, which are linked together thanks to a support and are spaced regularly the one from the others by a distance $d$.

Applying a plastic deformation in order to form crystallographic flaws with a comb results in a network of crystallographic flaws zones which are regularly spaced, and which spacing period is determined by the space between the tips of the comb.

A comb may comprise at least two, preferably at least five, in particular at least ten tips.

Preferably, the tips are made of a material which is harder than silicon, in particular in a material which Vickers hardness is greater than or equal 25.5 Hv.

According to a first particular embodiment, step b) of forming crystallographic flaws is performed via at least one compression operation of the predefined areas with a tip.

The compressive displacement $u$, preferably vertical, which is imposed to the tip in order that it compresses the predefined areas from the position to which it contacts the predefined area, is particularly greater than or equal 500 nm, preferably greater than 5 $\mu$m

The tip may then be translated in order to introduce a maximum of shear which is promotes the formation of crystallographic flaws below the predefined areas.

Then, according to a second particular embodiment, step b) is processed via at least one translation operation of a tip at the surface of a predefined area, in order to introduce a shear plastic deformation in the single crystalline silicon region.

These both particular embodiments as cited above might be combined, step b) possibly comprising at least a compression and a translation operation

In a variant of the invention, the crystallographic flaws are formed by laser radiation of the predefined areas.

Such a laser treatment is usually called laser shot peening and is well known by a man skilled in the art. The laser beam presents preferably one or more wave lengths greater than or equal to 100 nm, notably comprised between 400 to 5,000 nm.

Preferably, the laser treatment is performed with a laser beam which spot size is comprised between 1 $\mu$m to 20 $\mu$m, preferably between 2 $\mu$m to 5 $\mu$m.

Several radiation laser sources (55) may be used, in order to form a comb of beams which are regularly spaced the one from the others, in order to expose simultaneously the different predefined areas.

Alternatively, step b) may be performed by exposing successively every predefined area with the laser beam.

### c) Propagation of dislocations

The annealing step c) aims at propagating dislocations from the crystallographic flaws formed at step b) on a distance of at least 50% of the thickness of the substrate, as illustrated by figures 1)c) and 2)c).

As it is well known by a man skilled in the art, dislocation propagation is a thermally activated phenomenon. Therefore, as temperature is increased from room temperature, dislocation propagation throughout a crystalline material, and notably silicon, is eased and speeded up.

In step c), annealing aims at submitting the single crystalline silicon region to temperature that promote dislocations originating from the crystallographic flaws, for example *via* a well-known Frank and Read source, to move throughout the substrate.

In a preferred embodiment, the annealing operation for the propagation of the dislocations at step c) is carried out at a temperature comprised between 200°C and 1,100°C, preferably comprised between 400°C and 900°C.

The annealing operation for the propagation of dislocations is carried out for a time period of less than or equal to 3 hours, in particular comprised between 5 minutes to 2 hours, and more particularly between 10 minutes to 1 hour.

In a single crystalline silicon region comprising metallic impurities, propagated dislocations promote impurity precipitation along said dislocations by "anchoring" said impurities. Such a well-known phenomenon for a man skilled in the art is named as "heterogeneous precipitation". This mechanism has to be avoided since the decorated dislocations act as virulent recombination centers for charge carriers and affect the PV conversion efficiency. In a preferred embodiment, in particular for a single crystalline silicon region comprising metallic impurities, the annealing step c) and/or if the required the annealing step e), is carried out at a temperature of 600°C for 30 minutes. In this way, metallic impurities, especially those that diffuse slowly in silicon, in particular aluminum, are not efficiently anchored on the propagated dislocations. The generated dislocations are poorly electrically active.

Furthermore, dislocation movement in a silicon substrate is well known to be related to the imposed mechanical stress *via* the following relationship:

$$ v = B_0 \sigma^m \exp\left(-\frac{E_a}{k_B T}\right) $$

wherein:

-   $v$ is the dislocation velocity [m.s$^{-1}$],
-   $B_0$ is a constant which equals $2.1 \times 10^{-2}$ [m$^{2+m}$.N$^{-m}$.s$^{-1}$],
-   $\sigma$ is the stress imposed to the silicon substrate (in Pascal [Pa]),
-   $m$ is an exponent generally comprised between 0.9 and 1.4,
-   $E_a$ is the activation energy for a dislocation to move (which equals 2.2 eV),
-   $k_B$ is the well-known Bolzmann constant,
-   $T$ is the temperature (in Kelvin [K]).

Therefore, applying a mechanical stress field during the annealing step c) speeds up the dislocations propagation from the crystallographic flaws throughout the thickness of a substrate.

In a preferred embodiment, the single-crystalline silicon region is stressed by imposing a non-linear temperature profile and/or by bending said single-crystalline region.

In particular, in the case the substrate is in the form of a block or a plate, the non-linear temperature profile may consist in a square law type variation between the center and opposite edges of said block or plate. In this way, uniform stresses can be introduced along the length of the substrate. Indeed, the stress σ associated to a variation of temperature inside a substrate along a direction *x* is expressed as:

$$ \sigma = \alpha\, E\, W^2 \frac{\partial^2 T}{\partial x^2} $$

wherein:

-   $\alpha$ is the thermal expansion coefficient of silicon (about $3 \times 10^{-6}$ K$^{-1}$),
-   E is the Young modulus of silicon ($1.65 \times 10^{11}$ Pa),
-   W is a coefficient related to the dimension of the substrate that a man skilled in the art can compute from the knowledge of the dimensions of the single crystalline silicon region (in meters [m]).

In order to impose a non-linear profile of temperature between the center of the substrate and the two opposite edges, all techniques known by a man skilled in the art may be implemented. For example, a man skilled in the art knows how to use "cold" and "hot" heat sources, which are respectively applied in the center of the substrate and at said edges, in order that the temperature variation along the direction perpendicular to said opposite edges and which links said edges is non-linear, preferably square law type.

The temperature variation between the edge and the center of substrate may range between 0.1°C and 100°C, preferably between 2 °C and 10°C. The stress resulting from a temperature variation may range between 5 MPa and 2,000 MPa, preferably between 10 MPa and 300 MPa.

In another variant, the mechanical stresses may also be imposed by bending the single crystalline silicon region, in particular by performing a 3 point bending operation

As an example, the single crystalline silicon region may be bent by placing two opposite edges of the single crystalline silicon region on a support and by placing a load in the form of a body in the center of the single crystalline silicon region, in order to perform a three point bending operation.

For a three point bending operation, the resulting maximum stress $\sigma_m$ resulting from bending a square substrate of size $L$ is related to the force $F$ applied for bending via the following relationship:

$$\sigma_m = \frac{FLh}{8I}$$

with

$$I = \frac{Lh^3}{12}$$

wherein $h$ is the substrate thickness

This operation results in the development of internal stresses which speeds up the dislocation propagation along the thickness of a substrate more efficiently.

Preferably, in the bent substrate the maximum stress induced by bending is comprised between 5 and 2,000 MPa.

In order to prevent from any pollution, the supports on which the edges of the region are placed and/or the body placed at the center of the region are preferably made with high purity silicon. Preferably, the supports and/or the body are in the form of silicon beads.

In particular, the body mass is adapted depending on the temperature of the annealing step c). Preferably, the body mass is comprised between 0.3 g and 30 g. A man skilled in the art knows how to adapt such a body mass depending on the temperature and the dimensions of the single crystalline silicon region and/or the dimensions of the substrate.

According to a particular embodiment, mechanical stresses are at the same time obtained by imposing a non-linear temperature variation along the length of the single crystalline region and by bending said single crystalline region.

This annealing step c) may be carried out before and/or concurrently, and/or after step d). Step d) will be described hereafter.

In case step c) is carried out before step d), a step e) of annealing the single crystalline region under conditions suitable for the diffusion of hydrogen may be further carried out.

Preferably, at the end of step c), dislocations which have propagated from a crystallographic flaw zone formed at step b) along the thickness of said substrate, define a dislocation rich zone.

In a preferred embodiment, a dislocation rich zone presents a substantially prismatic shape, which generator extends over the vertical direction, and which basis corresponds to the shape of the crystallographic flaw zone at the end of step b), when observed in a vertical direction.

The average dislocation density of a hydrogen rich zone is greater than or equal to $10^3$ cm$^{-2}$, preferably greater than or equal to $10^4$ cm$^{-2}$ and more preferably greater than or equal to $10^5$ cm$^{-2}$.

In a particular embodiment, when observed along a vertical direction, the predefined areas overlap the dislocation rich zones.

At the end of step b), dislocations may have propagated such that the dislocation rich zone extends in the vertical direction through at least 50% of the single crystalline silicon region thickness, or even through said entire fitness $e$.

### d) Contacting propagated dislocations and/or crystallographic flaws with hydrogen

This step aims at contacting hydrogen with crystallographic flaws formed at step b) and/or the dislocation propagated at step c).

In a particular embodiment, hydrogen is contacted via hydrogen ionic implantation or via the deposition of a layer comprising hydrogen (60), in particular a hydrogenated silicon nitride layer (SiNx:H) or via hydrogen plasma. As shown by Dubois et al. [2], when applying a hydrogenated silicon nitride layer (SiNx:H) on the face of a single crystalline silicon region, atomic hydrogen would diffuse from said face in the region up to a depth of 50 $\mu$m at most after a rapid annealing (few seconds) at about 800-850°C. A man skilled in the art knows how to adapt the process conditions in order to contact hydrogen such as to obtain the willed hydrogen content in the single crystalline silicon region.

In an embodiment, at step d) hydrogen is contacted with at least the crystallographic flaws (30a; 30b) located in surface of at least one external surface of the single-crystalline silicon region.

Hydrogen may be contacted with the whole external surface of the single crystalline silicon region. Hydrogen may also be contacted only with the crystallographic flaw zones formed at step b). In a preferred embodiment, hydrogen is contacted with the entire surface of the single crystalline silicon region. In another preferred embodiment, hydrogen is contacted on at least a whole substrate face, even on the whole of both substrate faces.

In another embodiment, at step d) hydrogen is contacted with at least one external surface facing at least one external surface upon which crystallographic flaws (30a; 30b) are formed at step b), said process for hydrogenating further comprising a step e) of annealing at least said single-crystalline silicon region under conditions suitable for the diffusion of hydrogen along said dislocations. Preferably, said step e) is carried out in case step d) is carried out prior to step c).

Hydrogen may be contacted with a substrate face and/or a single crystalline silicon region face which is opposite to the surface wherein crystallographic flaws have been formed at step b). In particular, hydrogen may be contacted with parts of a substrate face and/or a single crystalline silicon region face, that face the crystallographic flaws have been formed on opposite face and which face the one with each other's.

In an embodiment, the substrate consists in a pile-up of a base region, a region providing hydrogen, for example a (SiNx:H) layer, and the single crystalline region, which may be formed on the region providing hydrogen. In this embodiment, the region providing hydrogen is sandwiched in between the base layer and the single crystalline region.

In the variant where hydrogen is contacted with a single crystalline silicon surface or a substrate face opposite to the external surface wherein the crystallographic flaws have been formed, a man skilled in the art knows how to adapt conditions for propagating dislocations such that hydrogen may contact said propagated dislocations. More preferably, propagation conditions are then adapted for dislocations to propagate throughout the thickness of said single crystalline silicon region such as to promote improved contact between hydrogen and said dislocations.

According to a variant of the invention, step d) of hydrogen contacting with crystallographic flaws and/or propagated dislocations is performed after annealing step c). However, as described here above, the depth reached by hydrogen from the single crystalline silicon region external surface after the introduction step being classically 50 $\mu$m at most, a further annealing step e) may be required in order to make hydrogen diffuse along the dislocations throughout the bulk of said silicon substrate.

In a preferred variant, the hydrogen contacting step d) is carried out before the annealing step c). Then hydrogen is first contacted with the single crystalline silicon region according to a classical method as described here above, and therefore remains concentrated close to the single crystalline silicon region surface. In this variant, the high temperature of the annealing step c) promotes the motion of dislocation through at least 50% of the substrate thickness along the vertical direction and hydrogen already contacted with the single crystalline region diffuses along diffusion canals induced by the propagated dislocations throughout the bulk of the single crystalline region, such as to define a hydrogen rich zone. In particular, hydrogen may diffuse deeper, in a vertical direction, from the single crystalline silicon region external surface throughout said region, than the depth reached by the propagated dislocations.

In a particular variant, the contacting with hydrogen step d) may also be performed before the step b) of forming crystallographic flaws, step c) being performed after step b). In this particular variant, hydrogen may be deposited in the form of a hydrogenated layer, preferably in the form of a hydrogenated silicon nitride layer (SiNx:H), or by plasma, on one face of the substrate, for example on a surface of the single crystalline silicon region. This hydrogenated layer may cover partially, preferably wholly said face. Then, crystallographic flaws are formed, preferably on the opposite substrate face such as to not damage said hydrogenated layer, preferably by scratching said face with a tip as previously described. Preferably, every part of the face on which hydrogen has been deposited faces an opposite predefined area on the opposite face overlapping a crystallographic flaw zone. By the way, dislocations propagated at the end of step c) extend over the substrate thickness and reach the hydrogen sources and define a diffusion channel for hydrogen, enabling further hydrogen diffusion during annealing step c) or annealing step e) throughout the single crystalline silicon region.

In another variant, step c) and step d) might be performed concurrently. In such a variant, during annealing of the silicon substrate, hydrogen is for example deposited in the form of a hydrogenated silicon nitride layer on the face of the substrate, such that said layer overlaps the predefined areas above which crystallographic flaws have been formed. Therefore, hydrogen may diffuse along said dislocations as soon as it has been contacted.

During the annealing operation promoting hydrogen diffusion, hydrogen diffuses from said dislocations, in a vertical cross section plan P, along a substantially horizontal direction, up to a distance measured from the dislocation core in a horizontal direction preferably greater than 10 microns, preferably greater than 20 microns and/or then preferably less than 100 microns, preferably less than 50 microns. It may then reach and interact with metallic impurities contained in the bulk of the single crystalline silicon region, as illustrated at figures 1)c) and 2)d).

As detailed here below, an annealing operation, either in the course of step c) or in the course of step e), has to be performed to promote conditions suitable for hydrogen to diffuse along the dislocations.

Preferably, the annealing operation for the diffusion of hydrogen along the dislocations, if present, is carried out a temperature comprised between 200°C and 900°C, in particular between 400°C and 800°C.

Preferably, the annealing operation for the diffusion of hydrogen along the dislocation is carried out for a period comprised between 2 seconds and 90 minutes, in particular between 4 seconds and 30 minutes.

## Hydrogenated substrate

The substrate (5), also hereafter named hydrogenated substrate, according to the invention is preferably obtained with a process for hydrogenating according to the invention.

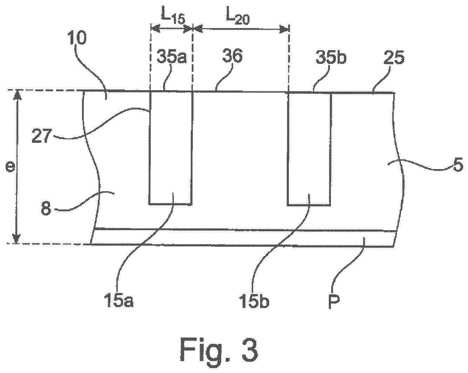

In particular, a substrate according to the invention comprises the following distinctive features as compared to the starting substrate as described here above. Reference is made in the following description to figure 3.

The external surface (25) of the single crystalline region comprises strain high areas (35a; 35b) in which are formed crystallographic flaws and a strain low area (36) located between the both strain high areas, without crystallographic flaws.

The average dislocation density in the hydrogen rich zone is greater than or equal to $10^3$ cm$^{-2}$, preferably greater than or equal to $10^4$ cm$^{-2}$ and more preferably greater than or equal to $10^5$ cm$^{-2}$.

The concentration of hydrogen in the hydrogen rich zone (8) of the single crystalline silicon region (10) of a substrate according to the invention is preferably greater than $10^{12}$ cm$^{-3}$, in particular comprised between $10^{13}$ cm$^{-3}$ and $10^{16}$ cm$^{-3}$.

Preferably the hydrogen rich zone (8) extends in the vertical direction over at least 75%, or even over said entire thickness e.

Preferably, the hydrogen rich zone (8) extends in the vertical direction from the external surface over at least 50 μm, even over at least 60 μm, even over at least over 75 μm, even over at least over 100 μm, even over at least 150 μm, even over at least 200 μm, even more over at least 300 μm.

The hydrogen rich zone may extend in the vertical direction over a distance which is greater than the distance over the dislocation rich zones extend, in a vertical direction.

Preferably, the dislocation rich zone (15a; 15b) extends in the vertical direction over at least 50%, preferably over 75% of the single crystalline silicon region thickness e, or even over said entire thickness e.

In particular, at least one, even all the dislocation rich zones (15a; 15b) outcrop to the same external face of the single crystalline region (25). In a variant, at least one, preferably all the dislocation rich zones outcrop to both opposite faces of the substrate, defining a dislocation channel extending between the both opposite faces.

Preferably, the dislocation rich zones and the hydrogen rich zone both extend over the entire single crystalline silicon region thickness e.

The external envelop (27) of the dislocation rich zone define a prism, which generator is substantially parallel to the vertical direction. For example, the external envelop has the shape of a parallelepiped or of a revolution cylinder.

The volume occupied by the dislocation rich zones is more than 1% and/or less than 80% of the volume of the single crystalline silicon region.

The strain high areas may have, independently of one another, a width $L_{15}$ measured in a direction normal to said vertical direction of less than or equal to 10 μm, in particular ranging from 0.1 μm to 10 μm

The distance $L_{20}$ between two successive strain high areas may range from 5 μm to 100 μm, in particular may be lower than or equal to 75 μm, and more partic-

ularly may range from 10 to 50 μm.

In particular, the distance between two strain high areas $L_{20}$ is less than 0.5 x e, even less than 0.2 x e, even less than 0.1 x e.

In the substrate according to the invention, a strain high area is separated by a strain low area. The strain high areas, observed along a vertical direction, may form a grid pattern or a pattern of substantially parallel bands.

Identifying the strain high areas from the strain low areas can easily be performed by a man skilled in the art.

**Process for the passivation of metallic impurities**

The process for hydrogenation of a single crystalline region as described above may consists in a step of a process for passivizing metallic impurities, more especially, for the passivation of metallic impurities contained in a single crystalline silicon region.

In particular, the single crystalline region may comprise a content of metallic impurities greater than $10^{10}$ cm$^{-3}$.

In particular, the substrate, more particularly the single crystalline region, comprises metallic impurities having a diffusion coefficient of less than or equal to $10^{-6}$ cm$^2$.s$^{-1}$ at 850°C.

In particular, the substrate, more particularly the single crystalline region, comprises metallic impurities in the group formed by aluminum, vanadium, titanium and mixtures thereof.

Preferably, the process for the passivation of metallic impurities according to the invention results in a silicon substrate according to the invention presenting improved electrical properties.

In order to reveal the presence of hydrogen in the substrate, a test may consist in firstly measuring the electrical properties of said substrate. Then, at least one of the surfaces is etched (metal electrodes and dielectric layers are removed) and the substrate is annealed at the temperature of 600°C for more than 1 hour. Following this annealing operation, the electrical properties are then measured. Whether the carrier lifetime are lowered by a factor of more than 1.3 confirms that hydrogen was present in the substrate prior to annealing and that it has diffused out of a substrate.

Among other possible techniques, in order to reveal the effect of hydrogen on the passivation of metallic impurities, the DLTS (as Deep Level Transient Spectroscopy) technique might be used. This technique might identify a flaw (for example a metallic impurity) in silicon that induce an energy level in the forbidden energy band and which results in the presence of one of more peaks in the DLTS signal with temperature. The temperature associated with a peak and the amplitude of this peak are notably dependent on the flaw concentration and on the position of the energy level induced by the flaw in the unallowable energy band. As an example, hydrogen, when combining with a metallic impurity modifies this energy level induced by the metallic impurity, resulting in a modified DLTS signal. The recombination parameters of a pair metallic impurity - hydrogen being known by a man skilled in the art for the metallic impurities considered therein, the DLTS technique can reveal hydrogenation of the substrate at a specific depth from a substrate face. As DLTS is a surface analysis method, probing a depth up to e/2 in silicon, the DLTS measurement is preferably performed on the face of the substrate according to the invention which is opposite to the face wherein a hydrogenated layer has been laid down prior to the passivation process.

## Photovoltaic devices

A man skilled in the art knows how to implement an adapted classical treatment, in order to manufacture a photovoltaic cell from a substrate as according to the invention.

According to another one of its aspects, the invention also relates to a photovoltaic modulus which is formed from photovoltaic cells according to the invention.

Now the invention will be described thanks to the following examples which are given to illustrate the invention in a non-limitative way.

## EXAMPLE

The following non limiting example is given for the purpose of illustrating the invention.

### (i) Substrate

A substrate is provided in the form of a (100) oriented p-type boron-doped single-crystalline silicon wafer, which dislocation density is less than $10^3$ cm$^{-2}$. This wafer has been obtained thanks to the well-known Czochralski pulling method It is in square form which size is 156 mm x 156 mm and has a thickness of 200 $\mu$m. It comprises copper and aluminum in concentrations of $10^{14}$ cm$^{-3}$ and $10^{16}$ cm$^{-3}$ respectively.

The substrate is firstly dipped in a KOH solution for etching the substrate surface. This chemical etching helps to texturize the resulting substrate surface by forming a network of pyramid surfaces, which allows reducing the substrate surface reflectivity while increasing the optical confinement effect.

Then the substrate is annealed in a tube furnace for a superficial phosphorus diffusion throughout the substrate, leading to the formation of a n+ emitter in the cell. This annealing step also induces an "external gettering scheme" which is particularly efficient for extracting copper from the substrate, as copper is an impurity which has a high diffusion coefficient.

### (ii) Contacting hydrogen with silicon

A layer of hydrogenated silicon nitride SiNx:H is laid down using the well-known Plasma-Enhanced Chemical Vapor Deposition (PECVD) on the entire surface of a first face of said substrate (front side of the cell).

### (iii) Formation of crystallographic flaws

The face opposite to the first face (rear side of the cell) is then scratched with a diamond micro-tip displaced such as to form a pattern of substantially parallel bands, two successive bands being separated by a distance of 20 $\mu$m. This scratching operation is performed with a diamond tip.

### (iv) Propagation of dislocations and hydrogen diffusion along said dislocations

The substrate is then annealed in a tube furnace scanned by a nitrogen flow for 30 minutes at a temperature of 600°C. The furnace is adapted for a quadratic variation temperature of 10°C is measured between both opposite edges and the centre of the wafer. A skilled worker knows how to adapt a furnace for imposing such thermal conditions, for example by using cold and hot sources close to the edges of the substrate.

This temperature field results in a homogeneous stress throughout the bulk of said substrate, which is estimated, following computation, to be close to 63 MPa.

During this annealing step, the dislocations propagate from said crystallographic flaws through the entire thickness thanks to the combination of high temperature and stress (since dislocation mobility is well known to be thermally activated), and at the end of said step, they extend over the whole thickness of the substrate and open on the opposite face of the substrate.

Diffusion of hydrogen also occurs during this annealing step. However, until the dislocation rich zones have not reached the opposite face covered by the hydrogenated silicon nitride layer, hydrogen diffusion is classically limited to less than 50 $\mu$m in the low dislocation density zones (which density is less than $10^3$ cm$^{-2}$) of the substrate below the opposite face.

Once the dislocation rich zones reach and outcrop to the opposite face covered by the hydrogenated silicon nitride layer, diffusion of hydrogen from the hydrogenated silicon nitride layer toward the bulk of the substrate is speeded up thanks to the hydrogen diffusion channels defined by the dislocations of the dislocation rich zones. At the end of the annealing step, hydrogen has scattered throughout the whole substrate, such as to define a hydrogen rich zone in the substrate. Hydrogen has also successfully passivized the metallic impurities, especially those having a low diffusion coefficient such as aluminum

Metallic electrodes are then deposited by serigraphy before a metallization annealing step (few seconds at 850°C). The junction is then opened, for example with a laser beam.

As is now clear, the invention provides a novel method making it possible to obtain a silicon substrate comprising a single crystalline region having enhanced electrical properties, said method being well able to cope with industrial constraints and yields.

Of course, the present invention is not limited to the embodiment described, which is only given for purposes of illustration.

For example, the formation of crystallographic flaws at step b) may be performed by a wire saw, in particular a diamond wire saw, being covered with particles, in particular diamond particles, which size and spatial distribution are chosen such as to form the crystallographic flaws.

For example, the step b) of forming crystallographic flaws may be performed at any step of the fabrication of a photovoltaic cell comprising a substrate according to the invention It may be performed before a step of phosphorus diffusion. This might help to limit the number of process steps for the fabrication of photovoltaic cells, since dislocations may propagate during a phosphorus diffusion step.

The here above phosphorus diffusion step may be the annealing step b) according to the invention, in particular when performed before the step of contacting the substrate with hydrogen. Preferably, a man skilled in the art knows how to adapt the conditions of this phosphorus diffusion step such as to promote the dislocation propagation, in particular such as to develop mechanical stresses in the bulk of the substrate for speeding up said propagation.

As another example, a hydrogenated silicon layer may be deposited on a single crystalline silicon region surface, said region being concurrently mechanically stressed, for example at a temperature of 500°C, such as to promote the dislocation propagation together with the diffusion of hydrogen in the bulk of said region.

**References:**

[1] Dubois S., Palais O., Ribeyron P.J., Enjalbert, N., Pasquinelli M and Martinuzzi S., Journal of Applied Physics, vol. 102, 083525 (2007),
[2] Dubois S., Palais O., Pasquinelli M, Martinuzzi S., Jaussaud C. and Rondel, N., Journal of Applied Physics, vol. 100, 024510 (2006),
[3] Martinuzzi S., Périchaud I. and Warchol F., Solar Energy Materials & Solar Cells, vol. 80, pp 343-353 (2003).

**Claims**

1. Substrate (5) comprising at least, preferably consisting of, a single-crystalline silicon region (10) having a thickness (e) between two opposite faces, **characterized in that** said region has, in a vertical cross-section plan (P), a hydrogen rich zone (8) which extends from at least a surface of one of the two opposite faces, in the vertical direction over at least 50 % of the thickness (e) of said single crystalline region, and in which the average dislocation density is greater than or equal to $10^3$ cm$^{-2}$, and **characterized in that** a part of the surface of one of the two opposite faces of the said region facing to the hydrogen rich zone (8) comprises strain high areas (35a; 35b) separated by a strain low area (36), the distance ($L_{20}$) between two successive strain high areas being comprised between 5 $\mu$m and 50% of said thickness (e) of said single crystalline silicon region, a "hydrogen rich zone" being a zone extending from the single crystalline silicon region external surface throughout at least 50% the thickness of said region, and comprising an average hydrogen concentration at least 1.5 times greater than the average hydrogen concentration of a neighboring zone.

2. Substrate as claimed in claim 1, said hydrogen rich zone extending over at least 75 % of said thickness (e), or even over the entire thickness (e) of said region.

3. Substrate as claimed in any one of the preceding claims, said single-crystalline silicon region having a thickness (e) of at least 10 $\mu$m preferably ranging from 10 $\mu$m to 800 $\mu$m, in particular from 20 $\mu$m to 300 $\mu$m, and more particularly of about 200 $\mu$m.

4. Substrate as claimed in any one of the preceding claims, wherein said strain high areas have, independently of one another, a width ($L_{15}$), measured in a direction normal to said vertical direction, of less than or equal to 10 $\mu$m, in particular ranging from 0,1 $\mu$m and 10 $\mu$m
and/or
the distance ($L_{20}$) between two successive strain high areas ranges from 5 $\mu$m to 100 $\mu$m, in particular is lower than or equal to 75 $\mu$m, and more particularly ranges from 10 $\mu$m to 50 $\mu$m.

5. Substrate as claimed in any one of the preceding claims, wherein said strain high areas, observed along a vertical direction, form a grid pattern or a pattern of substantially parallel bands.

6. A process for hydrogenating a single-crystalline silicon region of a substrate, comprising at least the following steps:

a) providing a substrate (5) comprising a single-crystalline silicon (10) region having a thickness (e) and at least one external surface (25), said single-crystalline region having preferably crystallographic plans (100) being normal to said external surface, said substrate being preferably a single crystal substrate;

b) forming crystallographic flaws (30a; 30b) at predefined areas (35a; 35b) of said external surface, said areas so called strain high areas being separated by a distance (d), measured along a direction normal to the vertical direction in a vertical cross-section plan (P), comprised between 5 $\mu$m and 50% of said thickness,

c) annealing at least said single-crystalline silicon region with conditions suitable for the propagation of dislocations from said crystallographic flaws (30a; 30b) along the vertical direction trough at least 50% of said thickness (e),

d) contacting with hydrogen at least one external surface (25) of said region with conditions suitable for the diffusion of hydrogen through or up to the dislocations.

7. The process as claimed in claim 6, wherein at step d) hydrogen is contacted with at least the crystallographic flaws (30a; 30b) located in surface of the at least one external surface of the single-crystalline silicon region

or

hydrogen is contacted with at least one external surface facing the at least one external surface upon which crystallographic flaws (30a; 30b) are formed at step b), said process further comprising a step e) of annealing at least said single-crystalline silicon region under conditions suitable for the diffusion of hydrogen along said dislocations, said step e) being preferably carried out in case step d) is carried out prior to step c).

8. The process as claimed in any one of claims 6 and 7, said crystallographic flaws being formed by scratching said predefined areas of the external surface with a tip (50), in particular with a diamond tip or a metallic tip, or said crystallographic flaws being formed by laser radiation (55) said predefined areas of the external surface.

9. The process as claimed in any one of claims 6 to 8, said predefined areas of the external surface forming a grid pattern or pattern of substantially parallel bands, when observed along a vertical direction.

10. The process as claimed in any one of claims 6 to 9, wherein, during the annealing operation for propagation of dislocations, said single-crystalline region is stressed by imposing a non-linear temperature profile and/or by bending said single-crystalline region.

gion.

11. The process as claimed in any one of claims 6 to 10, wherein the annealing operation for propagation of dislocations is carried out at a temperature comprised between 200°C and 1,100°C, preferably comprised between 400°C and 900°C and/or for a time period of less than or equal to 3 hours, in particular comprised between 5 minutes to 2 hours, and more particularly between 10 minutes to 1 hour.

12. The process as claimed in any one of claims 6 to 11, wherein hydrogen is contacted *via* hydrogen ionic implantation or *via* the deposition of a layer comprising hydrogen, in particular a hydrogenated silicon nitride layer (60) or via hydrogen plasma and/or hydrogen is contacted over the entire surface of said external surface

and/or

the step of contacting hydrogen is carried out before the step of annealing for propagation of dislocations.

13. The process as claimed in any one of claims 7 to 12, wherein the annealing operation for the diffusion of hydrogen along said dislocations is carried out at a temperature comprised between 200°C and 900°C, in particular between 400°C and 800°C and/or for a time period comprised between 2 seconds and 90 minutes, in particular between 4 seconds and 30 minutes.

14. A process for the passivation of metallic impurities (70) contained in a single-crystalline silicon region by hydrogenation of said single crystalline region *via* a process as claimed in any one of claims 6 to 13.

15. A photovoltaic device, in particular a photovoltaic cell, comprising a substrate as claimed in any one of claims 1 to 5 or obtained by a process as claimed in any one of claims 6 to 13.


**Patentansprüche**

1. Substrat (5), wenigstens umfassend einen, vorzugsweise bestehend aus einem, einkristallinen Siliciumbereich (10), der eine Dicke (e) zwischen zwei gegenüberliegenden Flächen aufweist, **dadurch gekennzeichnet, dass** der Bereich in einer senkrechten Schnittebene (P) eine wasserstoffreiche Zone (8) aufweist, die sich von wenigstens einer Oberfläche einer der beiden gegenüberliegenden Flächen in der senkrechten Richtung über wenigstens 50 % der Dicke (e) des einkristallinen Bereichs erstreckt, und bei dem die mittlere Versetzungsdichte größer als oder gleich $10^3$ cm$^{-2}$ ist, und **dadurch gekennzeichnet, dass** ein Teil der Oberfläche einer der beiden gegenüberliegenden Flächen des Bereichs, der der wasserstoffreichen Zone (8) zugewandt ist, Bereiche mit hoher Spannung (35a; 35b) umfasst, die von einem Bereich mit niedriger Spannung (36) getrennt sind,

der Abstand ($L_{20}$) zwischen zwei aufeinanderfolgenden Bereichen mit hoher Spannung in dem Bereich zwischen 5 μm und 50 % der Dicke (e) des einkristallinen Siliciumbereichs liegt,

eine "wasserstoffreiche Zone" eine Zone ist, die sich von der Außenoberfläche des einkristallinen Siliciumbereichs durch wenigstens 50 % der Dicke des Bereichs erstreckt und eine mittlere Wasserstoffkonzentration aufweist, die wenigstens 1,5-mal höher als die mittlere Wasserstoffkonzentration einer benachbarten Zone ist.

2. Substrat gemäß Anspruch 1, wobei sich die wasserstoffreiche Zone über wenigstens 75 % der Dicke (e) oder sogar über die gesamte Dicke (e) des Bereichs erstreckt.

3. Substrat gemäß einem der vorstehenden Ansprüche, wobei der einkristalline Siliciumbereich eine Dicke (e) von wenigstens 10 μm, vorzugsweise in dem Bereich von 10 μm bis 800 μm, insbesondere von 20 μm bis 300 μm, im Besonderen von etwa 200 μm, aufweist.

4. Substrat gemäß einem der vorstehenden Ansprüche, wobei die Bereiche mit hoher Spannung unabhängig voneinander eine Breite ($L_{15}$), gemessen in einer Richtung senkrecht zu der senkrechten Richtung, von kleiner als oder gleich 10 μm, insbesondere in dem Bereich von 0,1 μm bis 10 μm, aufweisen,

und/oder

der Abstand ($L_{20}$) zwischen zwei aufeinanderfolgenden Bereichen mit hoher Spannung in dem Bereich von 5 μm bis 100 μm liegt, insbesondere kleiner als oder gleich 75 μm ist und im Besonderen in dem Bereich von 10 μm bis 50 μm liegt.

5. Substrat gemäß einem der vorstehenden Ansprüche, wobei die Bereiche mit hoher Spannung, beobachtet entlang einer senkrechten Richtung, eine Gitterstruktur oder eine Struktur aus im Wesentlichen parallelen Bändern bilden.

6. Verfahren zum Hydrieren eines einkristallinen Siliciumbereichs eines Substrats, umfassend wenigstens die folgenden Schritte:

a) Bereitstellen eines Substrats (5), das einen einkristallinen Siliciumbereich (10) umfasst, der eine Dicke (e) und wenigstens eine Außenoberfläche (25) aufweist, wobei der einkristalline Bereich vorzugsweise kristallographische Ebenen (100) aufweist, die senkrecht zu der Außenoberfläche stehen, wobei das Substrat vorzugsweise ein einkristallines Substrat ist;
b) Bilden von kristallographischen Fehlern (30a, 30b) in definierten Bereichen (35a; 35b) der Außenoberfläche, wobei die so genannten Bereiche mit hoher Spannung um einen Abstand (d), gemessen entlang einer Richtung senkrecht zu der senkrechten Richtung in einer senkrechten Schnittebene (P), in dem Bereich zwischen 5 μm und 50 % der Dicke aufweisen;
c) Tempern wenigstens des einkristallinen Siliciumbereichs unter Bedingungen, die für die Ausbreitung von Versetzungen von den kristallographischen Fehlern (30a, 30b) entlang der senkrechten Richtung durch wenigstens 50 % der Dicke (e) geeignet sind;
d) Inkontaktbringen wenigstens einer Außenoberfläche (25) des Bereichs mit Wasserstoff unter Bedingungen, die für die Diffusion von Wasserstoff durch die oder zu den Versetzungen geeignet sind.

7. Verfahren gemäß Anspruch 6, wobei bei Schritt d) Wasserstoff mit wenigstens den kristallographischen Fehlern (30a, 30b) in Kontakt gebracht wird, die in der Oberfläche der wenigstens einen Außenoberfläche des einkristallinen Siliciumbereichs angeordnet sind,

oder

Wasserstoff mit wenigstens einer Außenoberfläche in Kontakt gebracht wird, die der wenigstens einen Außenoberfläche gegenüberliegt, auf der bei Schritt b) kristallographische Fehler (30a; 30b) gebildet werden, wobei das Verfahren ferner einen Schritt e) des Temperns des einkristallinen Siliciumbereichs unter Bedingungen umfasst, die für die Diffusion von Wasserstoff entlang der Versetzungen geeignet sind, wobei der Schritt e) vorzugsweise durchgeführt wird, falls der Schritt d) vor Schritt c) durchgeführt wird.

8. Verfahren gemäß einem der Ansprüche 6 und 7, wobei die kristallographischen Fehler durch Kratzen der vordefinierten Bereiche der Außenoberfläche mit einer Spitze (50) gebildet werden, insbesondere mit einer Diamantspitze oder einer metallischen Spitze, oder die kristallographischen Fehler durch Laserbestrahlung (55) der vordefinierten Bereiche der Außenoberfläche gebildet werden.

9. Verfahren gemäß einem der Ansprüche 6 bis 8, wobei die vordefinierten Bereiche der Außenoberfläche, beobachtet entlang einer senkrechten Richtung, eine Gitterstruktur oder eine Struktur aus im Wesentlichen parallelen Bändern bilden.

10. Verfahren gemäß einem der Ansprüche 6 bis 9, wobei während des Tempervorgangs zum Ausbreiten von Versetzungen der einkristalline Bereich unter Spannung gesetzt wird, indem ein nichtlineares Temperaturprofil angelegt wird und/oder der einkristalline Bereich gebogen wird.

**11.** Verfahren gemäß einem der Ansprüche 6 bis 10, wobei der Tempervorgangs zum Ausbreiten von Versetzungen bei einer Temperatur in dem Bereich zwischen 200 °C und 1.100 °C, vorzugsweise in dem Bereich zwischen 400 °C und 900 °C, und/oder über einen Zeitraum von weniger als oder gleich 3 Stunden, insbesondere in dem Bereich zwischen 5 Minuten und 2 Stunden, im Besonderen zwischen 10 Minuten und 1 Stunde, durchgeführt wird.

**12.** Verfahren gemäß einem der Ansprüche 6 bis 11, wobei Wasserstoff durch Wasserstoffionenimplantation oder durch die Abscheidung einer Schicht, die Wasserstoff umfasst, insbesondere einer hydrierten Siliciumnitridschicht (60), oder durch Wasserstoffplasma in Kontakt gebracht wird und/oder Wasserstoff über die gesamte Fläche der Außenfläche in Kontakt gebracht wird und/oder der Schritt des Inkontaktbringens mit Wasserstoff vor dem Schritt des Temperns zum Ausbreiten von Versetzungen durchgeführt wird.

**13.** Verfahren gemäß einem der Ansprüche 7 bis 12, wobei der Tempervorgang zur Diffusion von Wasserstoff entlang der Versetzungen bei einer Temperatur in dem Bereich zwischen 200 °C und 900 °C, insbesondere zwischen 400 °C und 800 °C, und/oder über einen Zeitraum in dem Bereich zwischen 2 Sekunden und 90 Minuten, insbesondere zwischen 4 Sekunden und 30 Minuten, durchgeführt wird.

**14.** Verfahren zum Passivieren metallischer Verunreinigungen (70), die in einem einkristallinen Bereich enthalten sind, durch Hydrieren des einkristallinen Bereichs durch ein Verfahren gemäß einem der Ansprüche 6 bis 13.

**15.** Photovoltaikvorrichtung, insbesondere eine Photovoltaikzelle, umfassend ein Substrat gemäß einem der Ansprüche 1 bis 5 oder erhalten durch ein Verfahren gemäß einem der Ansprüche 6 bis 13.

**Revendications**

**1.** Substrat (5) comprenant au moins, préférentiellement consistant en, une région de silicium monocristallin (10) ayant une épaisseur (e) entre deux faces opposées, **caractérisé en ce que** ladite région a, dans un plan en coupe transversale vertical (P), une zone riche en hydrogène (8) qui s'étend à partir d'au moins une surface de l'une des deux faces opposées, dans la direction verticale sur au moins 50 % de l'épaisseur (e) de ladite région monocristalline et dans laquelle la densité moyenne des dislocations est supérieure ou égale à $10^3$ cm$^{-2}$,
et **caractérisé en ce qu'**une partie de la surface de l'une des deux faces opposées de ladite région en regard de la zone riche en hydrogène (8) comprend des zones de déformation élevée (35a ; 35b) séparées par une zone de déformation faible (36), la distance ($L_{20}$) entre deux zones de déformation élevée successives étant comprise entre 5 $\mu$m et 50 % de ladite épaisseur (e) de ladite région de silicium monocristallin,
une « zone riche en hydrogène » étant une zone s'étendant à partir de la surface externe de la région de silicium monocristallin sur la totalité d'au moins 50 % de l'épaisseur de ladite région et comprenant une concentration moyenne en hydrogène au moins 1,5 fois plus grande que la concentration moyenne en hydrogène d'une zone voisine.

**2.** Substrat tel que revendiqué dans la revendication 1, ladite zone riche en hydrogène s'étendant sur au moins 75 % de ladite épaisseur (e) ou même sur toute l'épaisseur (e) de ladite région.

**3.** Substrat tel que revendiqué dans l'une quelconque des revendications précédentes, ladite région de silicium monocristallin ayant une épaisseur (e) d'au moins 10 $\mu$m, de préférence allant de 10 $\mu$m à 800 $\mu$m, en particulier de 20 $\mu$m à 300 $\mu$m, et plus particulièrement d'environ 200 $\mu$m.

**4.** Substrat tel que revendiqué dans l'une quelconque des revendications précédentes, dans lequel lesdites zones de déformation élevée ont, indépendamment les unes des autres, une largeur ($L_{15}$), mesurée dans une direction perpendiculaire à ladite direction verticale, inférieure ou égale à 10 $\mu$m, en particulier allant de 0,1 $\mu$m à 10 $\mu$m et/ou la distance ($L_{20}$) entre deux zones de déformation élevée successives va de 5 $\mu$m à 100 $\mu$m, en particulier est inférieure ou égale à 75 $\mu$m et plus particulièrement va de 10 $\mu$m à 50 $\mu$m.

**5.** Substrat tel que revendiqué dans l'une quelconque des revendications précédentes, dans lequel lesdites zones de déformation élevée, observées le long d'une direction verticale, forment un motif de grille ou un motif de bandes sensiblement parallèles.

**6.** Procédé pour l'hydrogénation d'une région de silicium monocristallin d'un substrat, comprenant au moins les étapes suivantes :

a) la mise à disposition d'un substrat (5) comprenant une région de silicium monocristallin (10) ayant une épaisseur (e) et au moins une surface externe (25), ladite région monocristalline ayant de préférence des plans cristallographiques (100) qui sont perpendiculaires à ladite surface externe, ledit substrat étant de préférence un substrat monocristallin ;

b) la formation de défauts cristallographiques (30a ; 30b) en des zones prédéfinies (35a ; 35b) de ladite surface externe, lesdites zones dites zones de déformation élevée étant séparées par une distance (d), mesurée le long d'une direction perpendiculaire à la direction verticale dans un plan en coupe transversale vertical (P), comprise entre 5 μm et 50 % de ladite épaisseur,

c) le recuit au moins de ladite région de silicium monocristallin avec des conditions appropriées pour la propagation de dislocations à partir desdits défauts cristallographiques (30a ; 30b) le long de la direction verticale sur au moins 50 % de ladite épaisseur (e),

d) la mise en contact d'au moins une surface externe (25) de ladite région avec de l'hydrogène avec des conditions appropriées pour la diffusion d'hydrogène dans les dislocations ou jusqu'à celles-ci.

7. Procédé tel que revendiqué dans la revendication 6, dans lequel à l'étape d) l'hydrogène est mis en contact au moins avec les défauts cristallographiques (30a ; 30b) situés en surface de l'au moins une surface externe de la région de silicium monocristallin ou l'hydrogène est mis en contact avec au moins une surface externe en regard de l'au moins une surface externe sur laquelle des défauts cristallographiques (30a ; 30b) sont formés à l'étape b), ledit procédé comprenant en outre une étape e) de recuit au moins de ladite région de silicium monocristallin dans des conditions appropriées pour la diffusion d'hydrogène le long desdites dislocations, ladite étape e) étant de préférence effectuée dans le cas où l'étape d) est effectuée avant l'étape c).

8. Procédé tel que revendiqué dans l'une quelconque des revendications 6 et 7, lesdits défauts cristallographiques étant formés par rayure desdites zones prédéfinies de la surface externe avec une pointe (50), en particulier avec une pointe en diamant ou une pointe métallique, ou lesdits défauts cristallographiques étant formés par exposition (55) desdites zones prédéfinies de la surface externe à un laser.

9. Procédé tel que revendiqué dans l'une quelconque des revendications 6 à 8, lesdites zones prédéfinies de la surface externe formant un motif de grille ou un motif de bandes pratiquement parallèles, lorsqu'elles sont observées le long d'une direction verticale.

10. Procédé tel que revendiqué dans l'une quelconque des revendications 6 à 9, dans lequel, pendant l'opération de recuit pour la propagation de dislocations, ladite région monocristalline est contrainte par l'imposition d'un profil de température non linéaire et/ou par la flexion de ladite région monocristalline.

11. Procédé tel que revendiqué dans l'une quelconque des revendications 6 à 10, dans lequel l'opération de recuit pour la propagation de dislocations est effectuée à une température comprise entre 200 °C et 1 100 °C, de préférence comprise entre 400 °C et 900 °C, et/ou pendant une durée inférieure ou égale à 3 heures, en particulier comprise entre 5 minutes et 2 heures et plus particulièrement entre 10 minutes et 1 heure.

12. Procédé tel que revendiqué dans l'une quelconque des revendications 6 à 11, dans lequel la mise en contact avec de l'hydrogène est effectuée par l'intermédiaire d'une implantation ionique d'hydrogène ou par l'intermédiaire du dépôt d'une couche comprenant de l'hydrogène, en particulier d'une couche de nitrure de silicium hydrogéné (60), ou par l'intermédiaire d'un plasma d'hydrogène et/ou la mise en contact avec de l'hydrogène est effectuée sur toute la surface de ladite surface externe et/ou l'étape de mise en contact avec de l'hydrogène est effectuée avant l'étape de recuit pour la propagation de dislocations.

13. Procédé tel que revendiqué dans l'une quelconque des revendications 7 à 12, dans lequel l'opération de recuit pour la diffusion d'hydrogène le long desdites dislocations est effectuée à une température comprise entre 200 °C et 900 °C, en particulier entre 400 °C et 800 °C, et/ou pendant une durée comprise entre 2 secondes et 90 minutes, en particulier entre 4 secondes et 30 minutes.

14. Procédé pour la passivation d'impuretés métalliques (70) contenues dans une région de silicium monocristallin par hydrogénation de ladite région monocristalline par l'intermédiaire d'un procédé tel que revendiqué dans l'une quelconque des revendications 6 à 13.

15. Dispositif photovoltaïque, en particulier une cellule photovoltaïque, comprenant un substrat tel que revendiqué dans l'une quelconque des revendications 1 à 5 ou obtenu par un procédé tel que revendiqué dans l'une quelconque des revendications 6 à 13.

Fig. 1

Fig. 2

Fig. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **AZZIZI A et al.** HYDROGEN PASSIVATION OF IRON IN CRYSTALLINE SILICON. *19TH EUROPEAN PHOTOVOLTAIC SOLAR ENERGY CONFERENCE,* 2004, 1021-1024
- **DUBOIS S. ; PALAIS O. ; RIBEYRON P.J. ; ENJALBERT, N. ; PASQUINELLI M ; MARTINUZZI S.** *Journal of Applied Physics,* 2007, vol. 102, 083525
- **DUBOIS S. ; PALAIS O. ; PASQUINELLI M ; MARTINUZZI S. ; JAUSSAUD C. ; RONDEL, N.** *Journal of Applied Physics,* 2006, vol. 100, 024510
- **MARTINUZZI S. ; PÉRICHAUD I. ; WARCHOL F.** *Solar Energy Materials & Solar Cells,* 2003, vol. 80, 343-353